# EUROPEAN PATENT APPLICATION

(11) **EP 3 705 945 A1**
(43) Date of publication of application: **09.09.2020**
(21) Application number: 19161469.2
(22) Date of filing: 08.03.2019
(51) Int. Cl.: G03F 9/00, G03F 7/20

(54) **METHODS AND APPARATUS FOR ESTIMATING SUBSTRATE SHAPE**

(71) Applicant: ASML Netherlands B.V., 5500 AH Veldhoven (NL)
(72) Inventor: DILLEN, Hermanus Adrianus, 5500 AH Veldhoven (NL); PLUG, Reinder Teun, 5500 AH Veldhoven (NL)
(74) Representative: ASML Netherlands B.V.

(57) **Abstract**

Methods and apparatus for estimating at least part of a shape of a surface of a substrate usable in fabrication of semiconductor devices. Methods comprise: obtaining at least one focal position of the surface of the substrate measured by an inspection apparatus, the at least one focal position for bringing targets on or in the substrate within a focal range of optics of the inspection apparatus; and determining the at least part of the shape of the surface of the substrate based on the at least one focal position.

## Description

### Field

The invention relates to methods and apparatus for estimating at least a part of a shape of a surface of a substrate (substrate shape), e.g. a wafer. In specific arrangements, the invention relates to the estimation of substrate shape based on at least one focal position of a substrate measured by an existing sensor of an inspection apparatus, such as a metrology apparatus.

### Background

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such a process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In current 3D device integration strategies (e.g. 3DNAND, Xpoint, MRAM etc.) substrates (or wafers) are coated with multiple layers of different materials (e.g. polysilicon, metals, organics etc.). This causes forces and stresses in the stack that can deform or warp the substrate from flat. This deformation results in the surface of the substrate exhibiting a particular shape, i.e. it is not flat or planar.

Warped substrates can cause a series of issues and challenges during the lithographic process such as when coating the substrate, clamping the substrate in the scanner, during focussing for scanner exposure, etc.

Knowledge of the wafer surface can help with speeding up alignment and leveling and possibly open up deposition/track and scanner controls.

Current methods and apparatus for determining wafer shape include a separate tool that does not comprise part of the lithographic track tool. Such tools therefore take up additional floor space in the fabrication environment and also require a substrate to be diverted into that separate tool, which takes additional time.

### Summary

The inventors have appreciated that existing tools within the lithographic tool track sense data that may be used to estimate the shape of a surface of the substrate.

According to an aspect of the invention, there is provided a method for estimating at least part of a shape of a surface of a substrate usable in fabrication of semiconductor devices, the method comprising: obtaining at least one focal position of the surface of the substrate measured by an inspection apparatus, the at least one focal position for bringing targets on or in the substrate within a focal range of optics of the inspection apparatus; and determining the at least part of the shape of the surface of the substrate based on the at least one focal position.

Optionally, the at least one focal position is measured by a sensor forming part of an apparatus for determining focus of the inspection apparatus.

Optionally, the optics of the apparatus for determining focus comprise an objective, and wherein the sensor is configured to determine the at least one focal position by determining a height of the surface of the substrate relative to the objective.

Optionally, the sensor is configured to determine a plurality of focal positions at a plurality of locations over the substrate.

Optionally, the inspection apparatus forms part of a lithographic track tool.

Optionally, the method further comprises supporting the substrate on a wafer table or an Epin.

Optionally, the substrate is supported on the wafer table, and wherein determining the at least part of the shape of the surface of the substrate is further based on a clamping force applied to the substrate.

Optionally, determining the at least part of the shape of the substrate is further based on distortion of the substrate imparted by the inspection apparatus.

Optionally, the method further comprises estimating the distortion of the substrate imparted by the inspection apparatus.

Optionally, estimating the distortion of the substrate imparted by the inspection apparatus comprises: obtaining, by the inspection apparatus, at least one focal position of a surface of a height reference substrate, the height reference substrate having a known freeform surface shape; determining at least part of the shape of the surface of the height reference substrate based on the at least one focal position of the surface of the height reference substrate; and estimating the distortion of the substrate imparted by the inspection apparatus based on the known freeform surface shape of the height reference substrate and the determined at least part of the shape of the surface of the height reference substrate.

Optionally, the method further comprises controlling a temperature within the inspection apparatus.

Optionally, the temperature is controlled by a cooling system forming part of the inspection apparatus.

Optionally, the temperature is controlled by controlling an amount and/or type of activity of the inspection apparatus.

Optionally, the amount and type of activity comprise an amount and type of activity of one or more motors or other actuators configured to control position of the substrate within the inspection apparatus.

Optionally, determining the at least part of the shape of the surface of the substrate is further based on a modelled thermal error in obtaining the focal position.

Optionally, the method further comprises modelling the thermal error.

Optionally, modelling the thermal error comprises: obtaining, by the inspection apparatus, at least one focal position of a surface of a thermal reference substrate at a plurality of times during operation of the inspection apparatus; determining at least part of the shape of the surface of the thermal reference substrate based on the at least one focal position obtained at the plurality of times; and modelling the thermal error based on the determined at least part of the shape of the surface of the thermal reference substrate at the plurality of times.

Optionally, modelling the thermal error further comprises sensing, by a temperature sensor, a temperate of the inspection apparatus at the plurality of times, the modelling being further based on the sensed temperature.

Optionally, the method further comprises obtaining the at least one focal position of the surface of the substrate at an edge of the substrate, and determining a location of one or more crystallographic orientation notches of the substrate based on the sensed parameter.

Optionally, the method further comprises transmitting data representing the determined at least part of the shape of the surface of the substrate and/or the location of the one or more crystallographic orientation notches to one or more further apparatus.

Optionally, the method further comprises configuring the one or more further apparatus based at least in part on the transmitted data.

Optionally, the further apparatus comprises a lithographic apparatus, the method further comprising aligning and/or levelling the substrate within the lithographic apparatus based on the at least part of the shape of the surface of the substrate and/or the location of the one or more notches.

According to an aspect of the invention, there is provided a method for determining a control parameter for an apparatus used in processing or inspection of a substrate usable in fabrication of semiconductor devices, the method comprising: obtaining values of the height of the surface of the substrate determined by a sensor configured to control the position of the substrate with respect to a focal plane of a first apparatus for processing or inspecting the substrate; and determining a control parameter for a second apparatus, different from the first apparatus, for processing or inspecting the substrate based on the values.

According to an aspect of the invention, there is provided an inspection apparatus for estimating at least part of a shape of a surface of a substrate usable in fabrication of semiconductor devices, the inspection apparatus comprising: a sensor configured to obtain at least one focal position of the surface of the substrate, the focal position for bringing targets on or in the substrate within a focal range of optics of the inspection apparatus; and a processor configured to execute computer program code to undertake the method of: obtaining at least one focal position; and determining the at least part of the shape of the surface of the substrate based on the at least one focal position.

According to an aspect of the invention, there is provided an inspection apparatus for determining a control parameter for a further apparatus used in processing or inspection of a substrate usable in fabrication of semiconductor devices, the inspection apparatus comprising one or more processors configured to execute computer program code to undertake the method of: obtaining values of the height of the surface of the substrate determined by a sensor configured to control the position of the substrate with respect to a focal plane of a first apparatus for processing or inspecting the substrate; and determining a control parameter for a second apparatus, different from the first apparatus, for processing or inspecting the substrate based on the values.

According to the invention in an aspect, there is provided a computer program comprising instructions which, when executed on at least one processor, cause the at least one processor to control an apparatus to carry out the method according to any described herein and particular as defined above.

According to the invention in an aspect, there is provided a carrier containing the computer mentioned above and elsewhere herein, wherein the carrier is one of an electronic signal, optical signal, radio signal, or non-transitory computer readable storage medium.

### Brief description of the drawings

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 shows a schematic representation of an objective above a substrate;
- Figure 5 shows a flow diagram of a method for estimating a shape of a surface of a substrate; and
- Figure 6 shows a schematic representation of a lithographic process flow.

### Detailed description

In the present document, the terms "radiation" and "beam" are used to encompass all types of electromagnetic radiation, including ultraviolet radiation (e.g. with a wavelength of 365, 248, 193, 157 or 126 nm), EUV (extreme ultra-violet radiation, e.g. having a wavelength in the range of about 5-100 nm) and SXR radiation having a wavelength in a range from 0.1 -100 nm.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

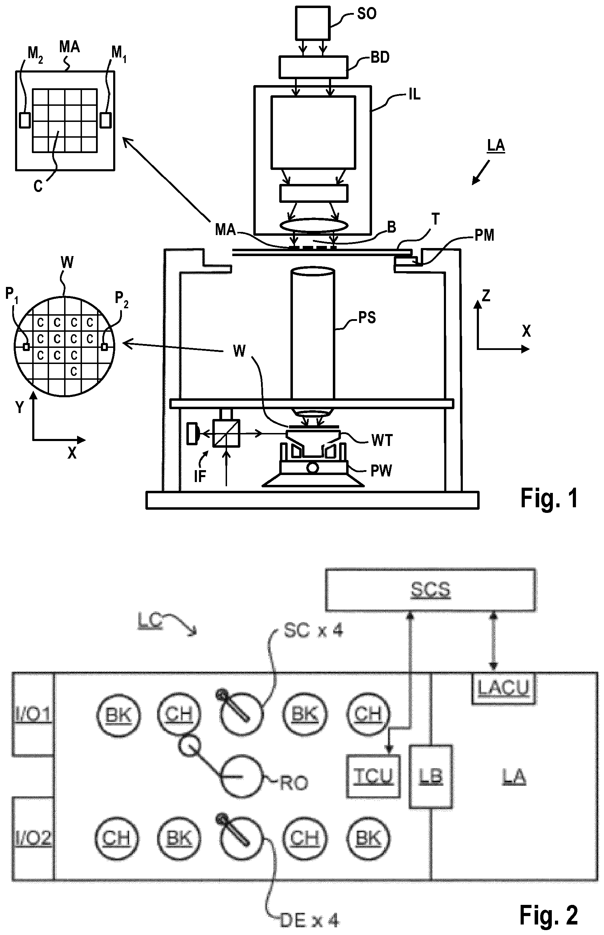

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS. The projection system may also be termed an optical system.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports (or substrate tables) WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor (or optical/radiation detector) and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

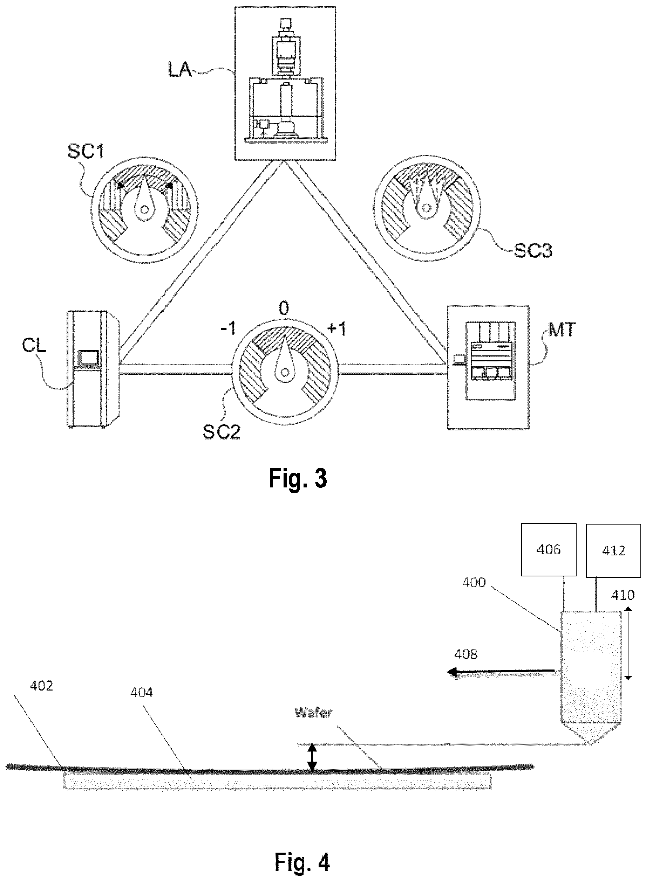

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool (or metrology apparatus) MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequent measurements of the structures created, e.g., for process control and verification. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In some examples, the scatterometer MT is an angular resolved scatterometer. In such a scatterometer, reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In other examples, the scatterometer MT is a spectroscopic scatterometer. In such spectroscopic scatterometers, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In yet further examples, the scatterometer MT is a ellipsometric scatterometer. The ellipsometric scatterometer allows for determining parameters of a lithographic process by measuring scattered radiation for each polarization states. Such a metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

The scatterometer MT may be adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717Alincorporated herein by reference in its entirety.

Inspection apparatus may be configured to undertake an autofocus routine. The autofocus routine is intended to determine a "fly height" for an objective, which forms part of the optics of the inspection apparatus, above a substrate. In order to achieve this, the inspection apparatus comprises a sensor configured to sense a parameter related to a height of the substrate. The parameter related to the height of the substrate may comprise one or more focal positions of the surface of the substrate. As used herein, the term "focal position" encompasses a distance of the surface of the substrate away from the objective when radiation focussed by the objective is focussed on the surface of the substrate.

In one exemplary arrangement, the sensor may be configured to sense a height of the objective above the substrate. A schematic representation of an objective 400 in an inspection apparatus is shown in Figure 4.

The substrate 402 is supported, for example on a wafer table 404. The inspection apparatus may comprise a motor 406 or the like that is connected to the objective 400 and configured to move the objective 400 and/or the substrate 402 or wafer table 404 in a direction shown by the arrow 408. The motor 406 (or a further motor) may also be configured to move one or both of the objective 400 and the wafer table 404 in a z-axis, which is transverse to a plane defined broadly by a surface of the substrate (not accounting for any warping) and shown by arrow 410.

The objective 400 has a particular focal length at which radiation from a radiation source is focussed and the motor 406 may move the objective 400 and/or wafer table 404 in the z-axis until the radiation is focussed onto a surface of the substrate 402.

A sensor 412 may be configured to determine the height of the objective 400. Because the focal length of the objective 400 is known, the height of the surface of the substrate 402 may be determined.

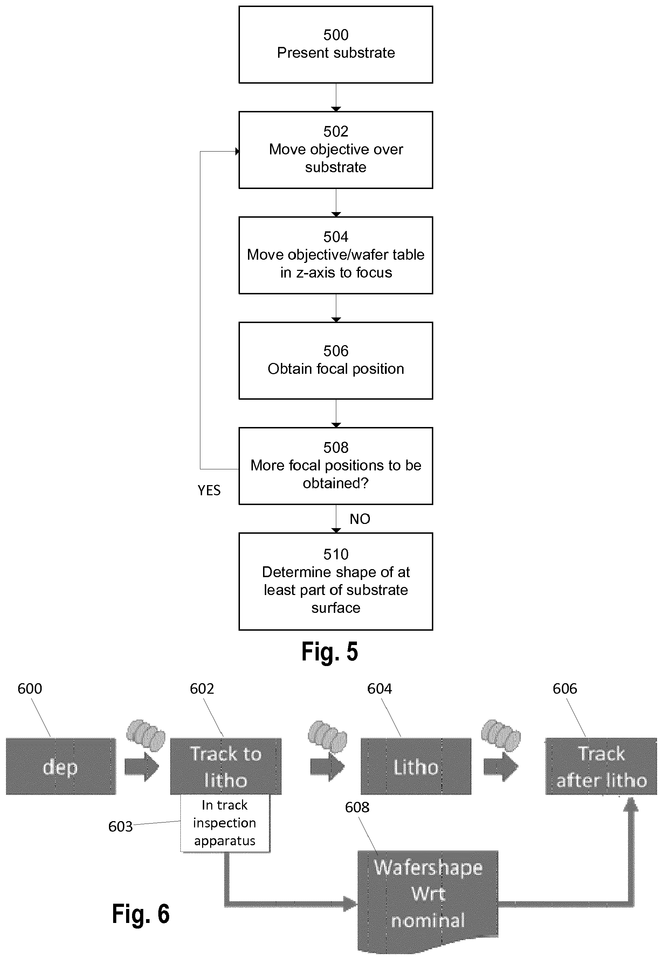

Figure 5 shows a flow diagram of a method for determining a shape of at least part of a surface of the substrate 402.

The substrate 402 is presented 500 to the inspection apparatus. The motor 406 moves 502 the objective 400 to a position above the substrate 402. As discussed above, the motor 406 operates to move 504 one or both of the objective 400 and the substrate 402 (e.g. via the wafer table 404) in the z-axis until the objective is focussed onto the surface of the substrate 402.

The sensor 412 senses 506 the focal position of the surface of the substrate, which in the exemplary arrangement discussed here is based on the height of the objective 400. This allows determination of the height of the surface of the substrate 402 as the focal length of the objective 400 is known.

In some exemplary arrangements, the height of the surface of the substrate 402 may be determined at a plurality of points to produce a point-based height map. Therefore, it is determined 508 whether further focal positions should be sensed by the sensor 412. If so, the method returns to step 502 and the objective 400 is moved to a further point over the substrate 402. This may be repeated as necessary.

A shape of at least part of the surface of the substrate may be determined 510 based on the sensed focal position or focal positions in the case of the point-based height map. In some arrangements, one or more mathematical processes may be undertaken on the point-based height map to determine the at least part of the shape of the substrate. For example, a curve-fitting or interpolation algorithm may be applied to the point-based height map.

It is noted that the term "height" as used herein encompasses a distance from the substrate 402 or a reference datum within the inspection apparatus and need not be a vertical distance.

The inspection apparatus is a lithographic track tool in that it forms part of the lithographic track. Accordingly, the substrate does not need to leave the lithographic track in order to determine the shape of the surface of the substrate.

The substrate 402 may be supported on a wafer table 404 or an Epin. If the substrate is supported on a wafer table 404, it may be clamped to the wafer table in ways known to the skilled person. In such arrangements, the at least part of the shape of the surface of the substrate 402 may be determined 510 based on the point-based height map and a clamping force applied to the substrate at one or more positions on the substrate. If the substrate is supported on an Epin, gravitational forces may affect the substrate 402 in unsupported regions. Accordingly, in such arrangements, the at least part of the shape of the surface of the substrate 402 may be determined based on the point-based height map and the effects of the gravitational forces on the substrate 402.

The inspection apparatus may itself apply some distortion to the substrate 402 when the substrate 402 is positioned therein. This inspection apparatus imparted distortion may result in a change to the freeform shape of the surface of the substrate 402. Accordingly, the inspection apparatus may be configured to determine 510 the at least part of the shape of the substrate based on distortion of the substrate imparted by the inspection apparatus.

In some exemplary arrangements, the inspection apparatus may be configured to estimate the distortion imparted by the apparatus itself. This may be done by presenting a further, height reference substrate to the inspection apparatus, wherein the height reference substrate has a known freeform surface shape. In exemplary arrangements, the surface of the height reference substrate may be substantially flat or planar and may be significantly flatter than substrates used in the fabrication of integrated circuits, such as those mentioned above. The height reference substrate is positioned in the inspection apparatus and may be supported in the same ways described above. Focal position(s) of the height reference substrate are obtained in similar ways to those described above and at least a part of the shape of the surface of the further substrate is determined. This represents the shape of the surface of the height reference substrate when it is positioned within the inspection apparatus. Based on the known freeform surface shape and the determined at least part of the shape of the surface of the height reference substrate, the distortion imparted on the substrate by the inspection apparatus may be estimated.

In some exemplary inspection apparatus, the objective and/or the substrate may be supported by a frame, the physical properties of which are affected by heat. For example, the inspection apparatus may comprise what is termed a c-frame, whereby the objective 400 is supported by a c-shaped metallic frame. During operation of the inspection apparatus, in particular based on the duty cycle of the one or more motors 406 for controlling the position of the objective 400 and/or the substrate, heat may be produced that, over time, may lead to thermal errors in the determination of the shape of the surface of the substrate 400 using methods and apparatus disclosed herein.

Accordingly, the inspection apparatus may be configured to mitigate for these thermal errors. In some exemplary arrangements, the thermal error may be tracked over time, for example, by retaining a single thermal reference substrate within the inspection apparatus over a significant period of time and during use of the tool. At least part of the shape of a surface of the thermal reference substrate may be determined using techniques disclosed herein at a plurality of times during operation of the inspection apparatus.

This determination may be repeated a plurality of times using the same or a different thermal reference substrate and with different levels of activity of the inspection apparatus over time. The resulting determined shapes of the at least part of the surface of the thermal reference substrate(s) may be used to estimate and model thermal error over time, and optionally against levels of activity of the inspection apparatus.

In some arrangements, the inspection apparatus may comprise a temperature sensor configured to sense temperature at the time the shape of the surface of the thermal reference substrate is determined. The thermal error may therefore additionally or alternatively be estimated and modelled against temperature. The modelled thermal error may be used to correct the determination of the shape of at least part of the substrates mentioned above.

In other arrangements, the effects of thermal error may be mitigated by a cooling system forming part of the inspection apparatus and configured to stabilise the temperature of the frame supporting the objective and/or the substrate. In some arrangements, the inspection apparatus may be configured to control a type and/or an amount of its activity (e.g. by limiting the movement and/or duty cycle of the motors). Controlling the type of activity may include use of a continuous scanning mode of operation rather than a stepped motion of the objective relative to the substrate.

Some exemplary methods and apparatus may be configured to determine a location of a crystallographic orientation notch cut into an edge of a substrate or wafer and that indicate the crystallographic planes of the substrate. Accordingly, methods and apparatus may be configured to sense the parameter (e.g. the height of the surface of the substrate 400) at an edge of the substrate 400. This may be done continuously around the edge or at a plurality of locations around the edge. Because notches are cut into the edge of the substrate, they manifest as sudden drops in the height of the surface of the substrate 400 when sensed using methods and apparatus disclosed herein.

As shown in Figure 6, data representing the shape of the surface of the substrate 400 may be transmitted to one or more further apparatus. The further apparatus may be configured based on the transmitted data.

As can be seen in Figure 6, substrates first go through a deposition stage 600 where a stack is deposited onto the substrate using techniques known to the skilled person. Then, in the track to litho 602 resist is applied to the stack, as required, in a number of application and bake steps. The inspection apparatus 603 disclosed herein may form part of the track to litho 602. That is, the inspection apparatus is "in track". In the litho step 604, the resist is exposed to fabricate device structure on the substrates 400. Following litho 604, in the track after litho 606, a metrology tool may be configured to determine one or more parameters relating to the accuracy of the litho process, for example OVL and CD.

The inspection apparatus 603 may transmit data 608 representing at least part of the shape of the surface of the substrates to the metrology tool in the track after litho 606.

A computer program may be configured to provide any part of the above described methods. The computer program may be provided on a computer readable medium. The computer program may be a computer program product. The product may comprise a non-transitory computer usable storage medium. The computer program product may have computer-readable program code embodied in the medium configured to perform the method. The computer program product may be configured to cause at least one processor to perform some or all of the method.

Various methods and apparatus are described herein with reference to, apparatus (systems and/or devices) and/or computer program products. Computer program instructions may be provided to a processor circuit of a general purpose computer circuit, special purpose computer circuit, and/or other programmable data processing circuit to produce a machine, such that the instructions, which execute via the processor of the computer and/or other programmable data processing apparatus, transform and control transistors, values stored in memory locations, and other hardware components within such circuitry to implement the functions/acts specified herein and thereby create means (functionality) and/or structure for implementing the functions/acts specified.

Computer program instructions may also be stored in a computer-readable medium that can direct a computer or other programmable data processing apparatus to function in a particular manner, such that the instructions stored in the computer-readable medium produce an article of manufacture including instructions which implement the functions/acts specified.

A tangible, non-transitory computer-readable medium may include an electronic, magnetic, optical, electromagnetic, or semiconductor data storage system, apparatus, or device. More specific examples of the computer-readable medium would include the following: a portable computer diskette, a random access memory (RAM) circuit, a read-only memory (ROM) circuit, an erasable programmable read-only memory (EPROM or Flash memory) circuit, a portable compact disc read-only memory (CD-ROM), and a portable digital video disc read-only memory (DVD/Blu-ray).

The computer program instructions may also be loaded onto a computer and/or other programmable data processing apparatus to cause a series of operational steps to be performed on the computer and/or other programmable apparatus to produce a computer-implemented process such that the instructions which execute on the computer or other programmable apparatus provide steps for implementing the functions/acts specified.

Accordingly, the invention may be embodied in hardware and/or in software (including firmware, resident software, micro-code, etc.) that runs on a processor, which may collectively be referred to as "circuitry," "a module" or variants thereof.

Further embodiment of the invention are disclosed in the list of numbered clauses below:
1. A method for estimating at least part of a shape of a surface of a substrate usable in fabrication of semiconductor devices, the method comprising:
   obtaining at least one focal position of the surface of the substrate measured by an inspection apparatus, the at least one focal position for bringing targets on or in the substrate within a focal range of optics of the inspection apparatus; and
   determining the at least part of the shape of the surface of the substrate based on the at least one focal position.
2. The method according to clause 1, wherein the at least one focal position is measured by a sensor forming part of an apparatus for determining focus of the inspection apparatus.
3. The method according to clause 2, wherein the optics of the apparatus for determining focus comprise an objective, and wherein the sensor is configured to determine the at least one focal position by determining a height of the surface of the substrate relative to the objective.
4. The method according to any preceding clause, wherein the sensor is configured to determine a plurality of focal positions at a plurality of locations over the substrate.
5. The method according to any preceding clause, wherein the inspection apparatus forms part of a lithographic track tool.
6. The method according to any preceding clause, further comprising supporting the substrate on a wafer table or an Epin.
7. The method according to clause 6, wherein the substrate is supported on the wafer table, and wherein determining the at least part of the shape of the surface of the substrate is further based on a clamping force applied to the substrate.
8. The method according to any preceding clause, wherein determining the at least part of the shape of the substrate is further based on distortion of the substrate imparted by the inspection apparatus.
9. The method according to clause 8, further comprising estimating the distortion of the substrate imparted by the inspection apparatus.
10. The method according to clause 9, wherein estimating the distortion of the substrate imparted by the inspection apparatus comprises:
   obtaining, by the inspection apparatus, at least one focal position of a surface of a height reference substrate, the height reference substrate having a known freeform surface shape;
   determining at least part of the shape of the surface of the height reference substrate based on the at least one focal position of the surface of the height reference substrate; and
   estimating the distortion of the substrate imparted by the inspection apparatus based on the known freeform surface shape of the height reference substrate and the determined at least part of the shape of the surface of the height reference substrate.
11. The method according to any preceding clause, further comprising controlling a temperature within the inspection apparatus.
12. The method according to clause 11, wherein the temperature is controlled by a cooling system forming part of the inspection apparatus.
13. The method according to clause 11 or 12, wherein the temperature is controlled by controlling an amount and/or type of activity of the inspection apparatus.
14. The method according to clause 13, wherein the amount and type of activity comprise an amount and type of activity of one or more motors or other actuators configured to control position of the substrate within the inspection apparatus.
15. The method according to any preceding clause, wherein determining the at least part of the shape of the surface of the substrate is further based on a modelled thermal error in obtaining the focal position.
16. The method according to clause 15, further comprising modelling the thermal error.
17. The method according to clause 16, wherein modelling the thermal error comprises:
   obtaining, by the inspection apparatus, at least one focal position of a surface of a thermal reference substrate at a plurality of times during operation of the inspection apparatus;
   determining at least part of the shape of the surface of the thermal reference substrate based on the at least one focal position obtained at the plurality of times; and
   modelling the thermal error based on the determined at least part of the shape of the surface of the thermal reference substrate at the plurality of times.
18. The method according to clause 17, wherein modelling the thermal error further comprises sensing, by a temperature sensor, a temperate of the inspection apparatus at the plurality of times, the modelling being further based on the sensed temperature.
19. The method according to any preceding clause, further comprising obtaining the at least one focal position of the surface of the substrate at an edge of the substrate, and determining a location of one or more crystallographic orientation notches of the substrate based on the sensed parameter.
20. The method according to any preceding clause, further comprising transmitting data representing the determined at least part of the shape of the surface of the substrate and/or the location of the one or more crystallographic orientation notches to one or more further apparatus.
21. The method according to clause 20, further comprising configuring the one or more further apparatus based at least in part on the transmitted data.
22. The method according to clause 21, wherein the further apparatus comprises a lithographic apparatus, the method further comprising aligning and/or levelling the substrate within the lithographic apparatus based on the at least part of the shape of the surface of the substrate and/or the location of the one or more notches.
23. A method for determining a control parameter for an apparatus used in processing or inspection of a substrate usable in fabrication of semiconductor devices, the method comprising:
   obtaining values of the height of the surface of the substrate determined by a sensor configured to control the position of the substrate with respect to a focal plane of a first apparatus for processing or inspecting the substrate; and
   determining a control parameter for a second apparatus, different from the first apparatus, for processing or inspecting the substrate based on the values.
24. A computer program comprising instructions which, when executed on at least one processor, cause the at least one processor to control an apparatus to carry out the method according to any preceding clause.
25. A carrier containing the computer program of clause 24, wherein the carrier is one of an electronic signal, optical signal, radio signal, or non-transitory computer readable storage medium.
26. An inspection apparatus for estimating at least part of a shape of a surface of a substrate usable in fabrication of semiconductor devices, the inspection apparatus comprising:
   a sensor configured to obtain at least one focal position of the surface of the substrate, the focal position for bringing targets on or in the substrate within a focal range of optics of the inspection apparatus; and
   a processor configured to execute computer program code to undertake the method of:
      obtaining at least one focal position; and
      determining the at least part of the shape of the surface of the substrate based on the at least one focal position.
27. An inspection apparatus for determining a control parameter for a further apparatus used in processing or inspection of a substrate usable in fabrication of semiconductor devices, the inspection apparatus comprising one or more processors configured to execute computer program code to undertake the method of:
   obtaining values of the height of the surface of the substrate determined by a sensor configured to control the position of the substrate with respect to a focal plane of a first apparatus for processing or inspecting the substrate; and
   determining a control parameter for a second apparatus, different from the first apparatus, for processing or inspecting the substrate based on the values.

It should also be noted that in some alternate implementations, the functions/acts noted may occur out of the order noted. Moreover, the functionality of a step may be separated into multiple steps and/or the functionality of two or more steps may be at least partially integrated. Finally, other steps may be added/inserted between the blocks that are illustrated.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method for estimating at least part of a shape of a surface of a substrate usable in fabrication of semiconductor devices, the method comprising:
obtaining at least one focal position of the surface of the substrate measured by an inspection apparatus, the at least one focal position for bringing targets on or in the substrate within a focal range of optics of the inspection apparatus; and
determining the at least part of the shape of the surface of the substrate based on the at least one focal position.

2. The method according to claim 1, wherein the at least one focal position is measured by a sensor forming part of an apparatus for determining focus of the inspection apparatus.

3. The method according to claim 2, wherein the optics of the apparatus for determining focus comprise an objective, and wherein the sensor is configured to determine the at least one focal position by determining a height of the surface of the substrate relative to the objective.

4. The method according to any preceding claim, wherein the sensor is configured to determine a plurality of focal positions at a plurality of locations over the substrate.

5. The method according to any preceding claim, wherein the inspection apparatus forms part of a lithographic track tool.

6. The method according to any preceding claim, further comprising supporting the substrate on a wafer table or an Epin.

7. The method according to claim 6, wherein the substrate is supported on the wafer table, and wherein determining the at least part of the shape of the surface of the substrate is further based on a clamping force applied to the substrate.

8. The method according to any preceding claim, wherein determining the at least part of the shape of the substrate is further based on distortion of the substrate imparted by the inspection apparatus.

9. The method according to claim 8, further comprising estimating the distortion of the substrate imparted by the inspection apparatus.

10. The method according to claim 9, wherein estimating the distortion of the substrate imparted by the inspection apparatus comprises:
obtaining, by the inspection apparatus, at least one focal position of a surface of a height reference substrate, the height reference substrate having a known freeform surface shape;
determining at least part of the shape of the surface of the height reference substrate based on the at least one focal position of the surface of the height reference substrate; and
estimating the distortion of the substrate imparted by the inspection apparatus based on the known freeform surface shape of the height reference substrate and the determined at least part of the shape of the surface of the height reference substrate.

11. The method according to any preceding claim, further comprising controlling a temperature within the inspection apparatus.

12. The method according to claim 11, wherein the temperature is controlled by a cooling system forming part of the inspection apparatus.

13. The method according to claim 11 or 12, wherein the temperature is controlled by controlling an amount and/or type of activity of the inspection apparatus.

14. The method according to claim 13, wherein the amount and type of activity comprise an amount and type of activity of one or more motors or other actuators configured to control position of the substrate within the inspection apparatus.

15. The method according to any preceding claim, wherein determining the at least part of the shape of the surface of the substrate is further based on a modelled thermal error in obtaining the focal position.
